# EUROPÄISCHE PATENTSCHRIFT

(11) **EP 1 474 266 B1**
(45) Veröffentlichungstag und Bekanntmachung des Hinweises auf die Patenterteilung: **04.04.2007**
(21) Anmeldenummer: 03706280.9
(22) Anmeldetag: 05.02.2003
(51) Int. Cl.: B23K 20/00, B23K 20/10, B23K 26/20

(54) **VERFAHREN ZUR HERSTELLUNG EINER BONDVERBINDUNG**
METHOD FOR PRODUCING A WIRE BONDING CONNECTION
PROCEDE POUR REALISER UNE SOUDURE DE FIL

(30) Priorität: 11.02.2002 DE 10205609
(43) Veröffentlichungstag der Anmeldung: 10.11.2004
(73) Patentinhaber: Infineon Technologies AG, 81669 München (DE)
(72) Erfinder: HOSSEINI, Khalil, 95466 Weidenberg (DE)
(74) Vertreter: Schäfer, Horst
(86) Internationale Anmeldenummer: PCT/DE2003/000325
(87) Internationale Veröffentlichungsnummer: WO 2003/068445

(56) Entgegenhaltungen:
- DE-A- 4 337 513
- DE-A- 4 437 484
- US-A- 4 597 520
- US-A- 5 492 263
- MAHHMOND R: "ADVANCES IN SINGLE-POINT TAPE AUTOMATED BONDING AN APPLICATION USING LASER AND ULTRASONIC ENERGY GAINS ACCEPTANCE FOR TAB AND SOLDER REFLOW" CONNECTOR SPECIFIER, IHS PUBLISHING,INC, US, Bd. 10, Nr. 1, 1994, Seiten 14-18, XP000450671 ISSN: 8756-4076

## Beschreibung

Die Erfindung betrifft ein Verfahren zur Herstellung einer Bondverbindung gemäß der Gattung des unabhängigen Anspruchs, Siehe US -A- 05 492 263.

Aus der Druckschrift DE 43 37 513 C2 ist eine Anordnung zum Erwärmen einer Bondstelle beim Golddraht-Thermosonic-Wirebonden bekannt. Die Bondstelle wird zur Absenkung der Verfahrenstemperatur von über 240 Grad C auf unter 170 Grad C mittels eines von einem Laser stammenden über einen Lichtwellenleiter geführten Laserstrahls für ein Golddraht-Thermosonic-Drahtbonden bestrahlt. Im Gegensatz zum Golddrahtbonden, das bei erhöhter Temperatur stattfindet, wird ein Kupfer- oder Aluminiumdrahtbonden bei Raumtemperatur durchgeführt. Die erforderliche Bondenergie wird aus einer Ultraschallquelle gewonnen und reicht aus, um Kupfer- oder Aluminiumbonddraht auf metallischen Oberflächen einer Kupfer-, Aluminium- oder Goldbeschichtung zu bonden.

Ähnliche Ansätze sind auch aus der US 5,492,263, der US 4,597,520, der DE 44 37 484 A1 und der Druckschrift "Advances in Single -Point Tape Automated Bonding", 8416 Interconnection Technology bekannt.

In der US 5,492,263 wird ein Verfahren zur Herstellung einer Aluminium-Drahtverbindung, genauer zur Herstellung eines Drahtkontaktes auf einem metallischen Flachleiter, mittels Ultraschallbonden ohne zusätzliche Wärmeenergie beschrieben.

Aus der US 4,597,520 ist ein speziellen Bondwerkzeugs, welches auch für dickere Bonddrähte geeignet ist und welches das Einbringen des Ultraschalls und das Abtrennen des Bonddrahts einfach und zuverlässig macht, bekannt.

In der DE 44 37 484 A1 wird eine Vorrichtung zur Drahtkontaktierung von Bauteilen beschrieben, welche es erlaubt, für bekannte Thermosonic- und Thermokompressionsbondverfahren die benötigte Wärmeenergie mittels Laserstrahl zuzuführen.

Im Übersichtsartikel "Advances in Single -Point Tape Automated Bonding", 8416 Interconnection Technology wird auf den Stand der Technik beim Ultraschall-Laserbondens und speziell auf verschiedene Lasertypen eingegangen.

Im Zuge der ständigen Kostenreduzierung unter Einsatz von anderen preiswerteren Bondstellenmaterialien, wie weichen Kupfermaterialien oder Hartmetallen, wie phosphorlegiertem Nickel als Bondstelle für Kupfer- oder Aluminiumbonddrähte, treten unerwartet Probleme auf, die zu vermehrtem Ausfall und Versagen der Bondverbindungen führen.

Aufgabe der Erfindung ist es, eine Anordnung zum Drahtbonden mit Kupferbonddraht zu schaffen und ein Verfahren zur Herstellung einer Bondverbindung mit Kupferbonddraht anzugeben, bei dem die Ausschussrate und die Fehlerhäufigkeit von Bondverbindungen vermindert wird.

Gelöst wird diese Aufgabe mit dem Gegenstand des unabhängigen Anspruchs. Vorteilhafte Weiterbildungen der Erfindung ergeben sich aus den abhängigen Ansprüchen.

Ein Verfahren zur Herstellung einer Bondverbindung mit einem Kupferbonddraht weist nachfolgende Verfahrensschritte auf. Zunächst wird mindestens eine der Bondstellen mit einem Hartmetall beschichtet, um einen Oxidationsschutz und eine Diffusionssperre zwischen Kupfer bonddraht und darunterliegendem, elektrisch leitendem Material zu erreichen. Weiterhin wird zur Vorbereitung der Bondverbindung das Wedge-Wedge-Ultraschall-Bondgerät mit einem Kupferbonddraht bestückt. Anschließend kann eine erste Wedge-Ultraschall-Bondverbindung unter Zuführung von Laserenergie ohne Abriss des Kupferbonddrahtes durchgeführt werden. Danach wird die Bondnadel mit Kupfer- oder Aluminiumbonddraht synchron mit einer Lichtwellenleiteroptik bis zu einer Suchhöhe einer zweiten Bondstelle mit Hartmetallbeschichtung synchron geführt. Bei Erreichen der Suchhöhe kann der Laser zur Aufheizung der Bondstelle erneut eingeschaltet werden und bleibt eingeschaltet während des Herunterfahrens der Bondnadel und der Lichtwellenleiteroptik auf die Bondposition. In der Bondposition erfolgt dann die Wedge-Ultraschall-Bondung des Kupferbonddrahtes auf der Hartmetallbeschichtung der zweiten Bondstelle, die jedoch an dieser Stelle durch die Lichtwellenleiteroptik eine erweichte Oberfläche aufweist.

Nach Einbringen von Ultraschallenergie und kurzer Rekristallisation wird die Bondnadel zusammen mit der Lichtwellenleiteroptik von der zweiten Bondstelle unter Abriss des Kupfer bonddrhates abgehoben. Dieses Verfahren hat den Vorteil, dass beim Abheben der Bondnadel die Bondverbindung zwischen Hartmetallbeschichtung und Kupfer bonddraht erhalten bleibt und nicht ein Abheben des Kupferbonddrahtes von der Hartmetallbeschichtung unter Aufreißen der Bondverbindungsstelle erfolgt.

Die Hartmetallbeschichtung selbst kann für beispielsweise mindestens eine zweite Bondstelle mittels eines Zerstäubungsverfahrens oder galvanisch erfolgen oder durch Aufdampftechnik aufgebracht werden. Sowohl bei der Zerstäubungstechnik als auch bei der Aufdampftechnik kann ein phosphorlegiertes Nickel aufgebracht werden, das als Diffusionssperre zwischen dem Bonddrahtmaterial und dem Material eines mit dem Bonddraht zu verbindenden Flachleiters oder einer Leiterbahn dient. Ein weiteres Verfahren zum Aufbringen des Hartmetalls bildet die Drucktechnik, bei der eine Hartmetallmischung in Form einer Paste aufgetragen wird und anschließend in einem kurzen Temperschritt zu einer Beschichtung zusammengesintert wird.

Der Abriss des Bonddrahtes kann bei einer weiteren Durchführung des Verfahrens durch Einkerben des Bonddrahtes, der einen Drahtdurchmesser über 100 µm aufweisen, erleichtert werden.

Zusammenfassend ist festzustellen, dass die Erfindung zur Verbesserung der Haftung und Bondqualität bei "Wedge-Wedge-Wirebonding" unter Anwendung von Ultraschall führt und eine bessere Bondbarkeit auf harten und empfindlichen Oberflächen verwirklicht. Darüber hinaus wird die Zuverlässigkeit der Bondverbindung durch die Rekristallisation bei unterschiedlichen Bondpartnern an der Grenzfläche erhöht. Ferner löst die Erfindung das Problem eines Drahtabhebens, dem sogenannten "lift off" des Bonddrahtes von harten Oberflächen, ohne die Ultraschall-Leistung erhöhen zu müssen, welche Maßnahme zum Teil zur Verschlechterung der Bondqualität, insbesondere auf Systemträgern, sogenannten "lead frames" führt.

Eine Erhöhung der Ultraschall-Leistung um bessere Bondergebnisse für einen Kupferbonddraht zu erzielen, bewirkt auf Weichmetallbeschichtungen einer Bondstelle eine Beschädigung der Chipmetallisierung, so dass das Erhöhen der Ultraschall-Leistung zur Verbesserung einer Bondverbindung eingeschränkt ist. Insofern ist das erfindungsgemäße Erwärmen der Bondfläche mit dem Einsatz eines Lasers ein effektives Mittel, um den Bondprozess zu stabilisieren und zu verbessern, das heißt die Oberfläche wird mit dem Laserstrahl während des sogenannten "touch down" der Bondnadel durch den Laserstrahl erwärmt. Durch die Erwärmung der Oberfläche wird das harte Metallgefüge weich und dieses führt zum Einbetten und zum Bonden des Kupferbonddrahtes auf dem Substrat oder in der Beschichtung der Bondstelle. Somit wird die Gefahr des "lift off" vermindert und auf empfindlichen Oberflächen kann mit einer geringeren Ultraschall-Leistung gebonded werden, so dass die Gefahr von Mikrorissen in einer weichen Chipmetallisierung vermieden wird.

Ferner ist anzumerken, dass bei dem erfindungsgemäßen Verfahren der Laserstrahl erst eingesetzt wird, nachdem die Bondnadel die Suchhöhe erreicht hat. Dieses erfolgt durch eine an der Bondnadel angebrachte Lichtwellenleiteroptik, welche mit gepulstem Laserstrahl beaufschlagt wird. Der Laserstrahl kann in seiner Impulsfolge, je nach Beschaffenheit der Oberfläche und der Größe der Bondfläche, durch eine geeignete Software angepaßt werden. Somit entsteht mit dem erfindungsgemäßen Verfahren eine lokal weiche Oberfläche, während sich die Bondnadel in Richtung auf die Oberfläche bewegt. Um sowohl den Bonddraht als auch die Bondstelle vor Oxidation und Sulfidation zu schützen, kann während des gesamten Bondvorgangs mit einer Schutzgasatmosphäre die Bondstelle gespült werden.
- Figur 1: zeigt eine Prinzipskizze einer Anordnung zum Drahtbonden unter Erwärmung einer ersten Bondstelle,
- Figur 2: zeigt eine Prinzipskizze einer Anordnung zum Drahtbonden unter Erwärmung einer zweiten Bondstelle,
- Figur 3: zeigt eine Prinzipskizze einer Anordnung zum Drahtbonden nach Fertigstellung einer Bondverbindung,
- Figur 4: zeigt eine Prinzipskizze einer Anordnung zum Drahtbonden unter Abheben des Bonddrahtes von der zweiten Bondstelle bei Ausfall der Lasererwärmung.

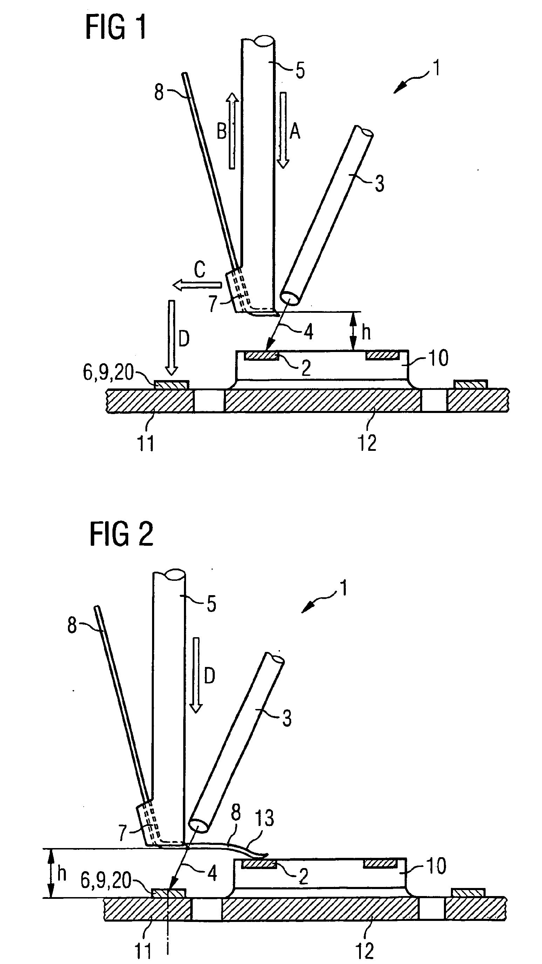

Figur 1 zeigt eine Prinzipskizze einer Anordnung 1 zum kupfer drahtbonden unter Erwärmung einer ersten Bondstelle 2. Das Bezugszeichen 3 kennzeichnet eine Lichtwellenleiteroptik, mit der die Bondstelle 2 mittels eines Laserstrahls 4 belichtet und erwärmt werden kann. Das Bezugszeichen 5 kennzeichnet eine Bondnadel, an deren Spitze ein Kupferbonddraht 8 in einer Kupfer- oder Aluminiumbonddrahtführung 7 gehalten wird. Sobald in einem vorbestimmten Abstand von der Bondstelle 2 die Suchhöhe h erreicht ist, wird der Laserstrahl 4 eingeschaltet und auf die Bondstelle 2 durch die Lichtwellenleiteroptik 3 konzentriert.

Während die Bondnadel 5 in Pfeilrichtung A auf die Bondstelle 2 zufährt, bleibt der Laserstrahl 4 eingeschaltet und erwärmt die Bondstelle. Durch die Erwärmung der Bondstelle wird das Bonden bei niedriger Ultraschallenergie erleichtert. Diese Ultraschallenergie wird über die Bondnadel 5 auf den Kupferbondraht 8 übertragen und bewirkt eine Kaltverschweißung der Oberflächen des Bonddrahtes 8 und der Oberflächen des Metalls der Bonstelle 2. Nach dem Herstellen einer ersten Bondverbindung wird die Bondnadel in Pfeilrichtung B angehoben und in Pfeilrichtung C verbracht, um über der zweiten Bondposition 20 zum Stehen zu kommen.

Während die erste Bondposition mit der Bondstelle 2 auf einem Halbleiterchip 10 angeordnet ist, liegt die zweite Bondstelle 20 auf einem Flachleiter 11 eines Systemträgers 12 aus Kupfer. Die zweite Bondstelle 20 ist mit einem Hartmetall 9 aus phosphorlegiertem Nickel beschichtet, um eine Oxidation und eine Diffusion des Kupfermaterials des Systemträgers 12 zu der Bondstelle des Kupferbonddrahtes zu verhindern. Bevor in Pfeilrichtung D die Bondnadel 5 auf die Hartmetallbeschichtung 6 der zweiten Bondstelle 20 abgesengt wird, wird deshalb wiederum die Lichtwellenleiteroptik 3 mit Laserlicht gespeist und erwärmt die Oberfläche der Hartmetallbeschichtung 6, wodurch sich die Eigenschaften der Hartmetallbeschichtung 6 in der Weise ändern, dass die Härte der Oberfläche abnimmt.

Figur 2 zeigt eine Prinzipskizze einer Anordnung zum Drahtbonden unter Erwärmung einer zweiten Bondstelle. Komponenten mit gleichen Funktionen wie in Figur 1 werden mit gleichen Bezugszeichen gekennzeichnet und nicht extra erörtert.

Aufgrund der Relativbewegungen der Bondnadel 9 gegenüber den Bondstellen 2 und 20 in den in Figur 1 gezeigten Richtungen A, B, C und D wird der auf der ersten Bondstelle 2 gebondete Kupferbonddraht 8 durch die Bonddrahtführung 7 hindurchgezogen und bildet einen Bonddrahtbogen 13, der ausreicht, um zugspannungsfrei den Kupferbonddraht 8 zur zweiten Bondstelle 20 zu führen. Nachdem die Suchhöhe h für die zweite Bondstelle 20 erreicht ist, wird wiederum die Laserversorgung eingeschaltet und ein Impulslaserstrahl 4 wärmt die Oberfläche der Hartmetallbeschichtung 6 auf, so dass die Härte vermindert wird und die Bondnadel 5 kann auf die Bondposition der zweiten Bondstelle 20 in Pfeilrichtung D abgesenkt werden.

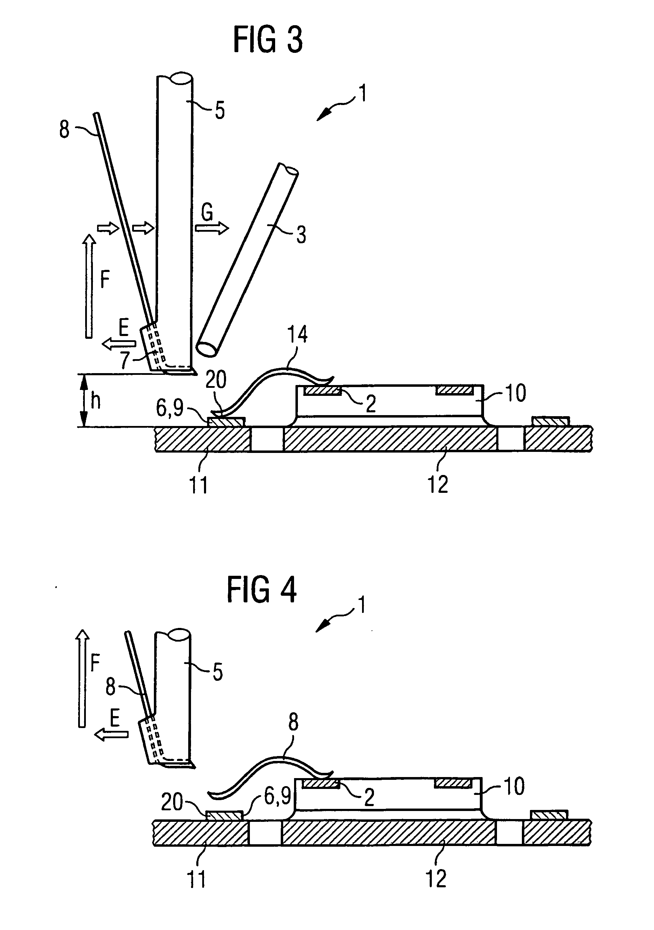

Figur 3 zeigt eine Prinzipskizze einer Anordnung zum Drahtbonden nach Fertigstellung einer Bondverbindung 14. Komponenten mit gleichen Funktionen wie in den vorhergehenden Figuren werden mit gleichen Bezugszeichen gekennzeichnet und nicht extra erörtert.

Dazu wird die Bondnadel 5 in Pfeilrichtung E von der Bondstelle 20 weggeführt, wobei,der Kupfer bonddraht 8 hinter der Bondstelle 20 abreißt. Ist der Kupferbonddraht 8 dicker als 100 µm, so wirkt sich ein in der Kupfer bonddrahtführung 7 angeordnetes Kerbwerkzeug aus, das vor dem Wegführen der Bondnadel 5 in Richtung E eine Kerbe in den Kupferbonddraht 8 eindrückt. Ist der Kupferbonddraht 8 unter 100 µm, wirkt sich das Kerbwerkzeug nicht aus, da der Bonddraht an dem Kerbwerkzeug in der Kupferbonddrahtführung 7 vorbeigleiten kann.

Nach dem erfolgreichen Abriss des Kupferbonddrahtes 8 kann die Bondnadel 5 in Pfeilrichtung F angehoben werden und in Pfeilrichtung G auf seine Ausgangsposition, die in Figur 1 gezeigt wird, zurückgeführt werden. Da es sich bei den Bewegungsrichtungen in Pfeilrichtung A bis G um Relativbewegungen zwischen Bondnadel 5 und Bondstellen 2, 20 handelt, kann anstelle der Bondnadel 5 auch der Systemträger mit der ersten und zweiten Bondstelle 2 bzw. 20 bewegt werden. Eine mögliche Aufteilung der Bewegungsrichtungen X, Y und Z in einem karthesischen Koordinatensystem kann bei einer Anordnung für ein Wedge-Wedge-Ultraschall-Bondgerät darin bestehen, dass die Bondnadel 5 sämtliche vertikalen Bewegungen in Z-Richtung durchführt, während der Systemträger mit den Bondstellen 2, 20 in der Systemträgerebene in den Richtungen X und Y bewegt wird.

Figur 4 zeigt eine Prinzipskizze einer Anordnung zum Drahtbonden unter Abheben des Bonddrahtes von der zweiten Bondstelle bei einem Ausfall der Lasererwärmung. Komponenten mit gleichen Funktionen wie in den vorhergehenden Funktionen werden mit gleichen Bezugszeichen gekennzeichnet und nicht extra erörtert.

Wird die Erwärmung einer Hartmetallbeschichtung durch einen Laser weggelassen, besteht die Gefahr, dass beim Wegführen der Bondnadel 5 in Pfeilrichtung E und F, der Bonddraht 8 nicht nur abreißt, sondern gleichzeitig von der Bondstelle 20 abgehoben wird, so dass keine perfekte Bondverbindung entsteht. Dieser Fehler, wie er in Figur 4 gezeigt wird, kann durch den Einsatz einer Erwärmung der Oberfläche des Hartmetalls 9 in der zweiten Bondposition 20 wie es die Figuren 2 und 3 zeigen vermieden werden.

## Patentansprüche

1. Verfahren zur Herstellung einer Bondverbindung mit einem Kupferbonddraht (8), das folgende Verfahrensschritte aufweist:
- Beschichten mindestens einer der Bondstellen (2, 20) mit einem Hartmetall (9),
- Bestücken eines Wedge-Wedge-Ultraschall-Bondgerätes mit einem Kupferbonddraht (8),
- Durchführen einer 1. Wedge-Ultraschall Bondverbindung unter Zuführung von Laserenergie ohne Abriss des Kupferbonddrahtes (8),
- Hinführen einer Bondnadel (5) mit Kupferbonddraht (8) synchron mit einer Lichtwellenleiteroptik (3) bis zu einer Suchhöhe (h) über der Bondstelle (2) der Hartmetallbeschichtung (6),
- Einschalten eines Lasers zur Aufheizung der Bondstelle (2),
- Herunterfahren von Bondnadel (5) und einer Lichtwellenleiteroptik (3) bei eingeschaltetem Laser in eine Bondposition mit Hartmetallbeschichtung (6) auf der Bondstelle (20),
- Wedge-Ultraschallbonden des Kupferbonddrahtes (8) auf der Hartmetallbeschichtung (6),
- Abheben der Bondnadel (5) und der Lichtwellenleiteroptik- (3) von der zweiten Bondstelle (2) unter Abriss des Kupferbonddrahtes (8).

2. Verfahren nach Anspruch 1,
**dadurch gekennzeichnet, dass**
das Beschichten mindestens einer Bondstelle (2, 20) mit einem Hartmetall (9) mittels Zerstäubungsverfahren oder galvanisch erfolgt.

3. Verfahren nach Anspruch 1,
**dadurch gekennzeichnet, dass**
das Beschichten mindestens einer Bondstelle (2., 20) mit einem Hartmetall (9) mittels Aufdampftechnik erfolgt.

4. Verfahren nach Anspruch 1,
**dadurch gekennzeichnet, dass**
das Beschichten mindestens einer Bondstelle (2, 20) mit einem Hartmetall (9) mittels Drucktechnik erfolgt.

5. Verfahren nach einem der Ansprüche 1 bis 4,
**dadurch gekennzeichnet, dass**
der Abriss des Kupferbonddrahtes (8) beim Abheben der Bondnadel (5) für Drahtdurchmesser über 100 um nach vorherigem Einkerben des Kupferbonddrahtes (8) erfolgt.

## Claims

1. Process for producing a bonded join using a copper bonding wire (8), which includes the following process steps:
- coating at least one of the bonding locations (2, 20) with a hard metal (9),
- mounting a copper bonding wire (8) in an ultrasonic wedge-wedge bonding unit,
- carrying out a first ultrasonic wedge bonding join by supplying laser energy without detaching the copper bonding wire (8),
- guiding a bonding needle (5) with copper bonding wire (8) synchronously with optical waveguide optics (3) up to a search height (h) above the bonding location (2) of the hard-metal coating (6),
- switching on a laser in order to heat the bonding location (2),
- moving the bonding needle (5) and optical waveguide optics (3) downward, with the laser switched on, into a bonding position with the hard-metal coating (6) at the bonding location (20),
- ultrasonic wedge bonding of the copper bonding wire (8) to the hard-metal coating (6),
- lifting the bonding needle (5) and the optical waveguide optics (3) off the second bonding location (2), with the copper bonding wire (8) being detached.

2. Process according to Claim 1, **characterized in that** the coating of at least one bonding location (2, 20) with a hard metal (9) is carried out by means of sputtering processes or by electroplating.

3. Process according to Claim 1, **characterized in that** the coating of at least one bonding location (2, 20) with a hard metal (9) is carried out by means of vapor deposition.

4. Process according to Claim 1, **characterized in that** the coating of at least one bonding location (2, 20) with a hard metal (9) is carried out by means of printing technology.

5. Process according to one of Claims 1 to 4, **characterized in that** the detachment of the copper bonding wire (8) when the bonding needle (5) is being lifted off, for wire diameters of over 100 µm, is carried out after prior notching of the copper bonding wire (8).

## Revendications

1. Procédé de réalisation d'une soudure à l'aide d'un fil de soudage (8) en cuivre, lequel procédé présente les étapes de procédé suivantes :
- revêtement d'au moins l'un des emplacements de soudage (2, 20) par un métal dur (9),
- installation d'un fil de soudage (8) en cuivre sur un appareil de soudage en biseau-biseau par ultrasons,
- réalisation d'une première soudure en biseau par ultrasons tout en apportant de l'énergie laser et sans rompre le fil de soudage (8) en cuivre,
- rapprochement d'une pointe de soudage (5) dotée d'un fil de soudage (8) en cuivre en synchronisme avec une optique (3) à conducteur d'ondes lumineuses jusqu'à une hauteur de recherche (h) au-dessus de l'emplacement de soudage (2) du revêtement (6) en métal dur,
- branchement d'un laser pour chauffer l'emplacement de soudage (2),
- abaissement de la pointe de soudage (5) et d'une optique (3) à conducteur d'ondes lumineuses, le laser étant branché, jusque dans une position de soudage sur le revêtement (6) en métal dur à l'emplacement de soudage (20),
- soudage en biseau par ultrasons du fil de soudage (8) en cuivre sur le revêtement (6) en métal dur et ,
- relèvement de la pointe de soudage (5) et de l'optique (3) à conducteur d'ondes lumineuses par rapport au deuxième emplacement de soudage (2), avec rupture du fil de soudage (8) en cuivre.

2. Procédé selon la revendication 1, **caractérisé en ce que** le revêtement par un métal dur (9) d'au moins un emplacement de soudage (2, 20) est réalisé par un procédé de pulvérisation ou par voie galvanique.

3. Procédé selon la revendication 1, **caractérisé en ce que** le revêtement d'au moins un emplacement de soudage (2, 20) par un métal dur (9) s'effectue par une technique de vaporisation.

4. Procédé selon la revendication 1, **caractérisé en ce que** le revêtement d'au moins un emplacement de soudage (2, 20) par un métal dur (9) s'effectue au moyen d'une technique d'impression.

5. Procédé selon l'une quelconque des revendications 1 à 4, **caractérisé en ce que** la rupture du fil de soudage (8) en cuivre lors de l'éloignement de la pointe de soudage (5) s'effectue après entaillage du fil de soudage (8) en cuivre lorsque le diamètre du fil est supérieur à 100 µm.
